# EUROPÄISCHE PATENTSCHRIFT

(11) **EP 1 552 544 B1**
(45) Veröffentlichungstag und Bekanntmachung des Hinweises auf die Patenterteilung: **21.12.2011**
(21) Anmeldenummer: 03747792.4
(22) Anmeldetag: 15.10.2003
(51) Int. Cl.: H01J 37/34, C23C 14/35, C23C 14/54

(54) **Verfahren zur Herstellung magnetron-sputterbeschichteter Substrate und Anlage hierfür**
Method for the production of a substrate with a magnetron sputter coating and unit for the same
Procédé pour produire des substrats revétus par pulverisation cathodique magnetron et installation correspondante

(30) Priorität: 15.10.2002 US 418542 P
(43) Veröffentlichungstag der Anmeldung: 13.07.2005
(73) Patentinhaber: Oerlikon Trading AG, Trübbach, 9477 Trübbach (CH)
(72) Erfinder: ZÜGER, Othmar, FL-9495 Triesen (LI)
(74) Vertreter: Troesch, Jacques J.
(86) Internationale Anmeldenummer: PCT/CH2003/000674
(87) Internationale Veröffentlichungsnummer: WO 2004/036616

(56) Entgegenhaltungen:
- WO-A-00/71774
- US-A- 5 171 415
- US-A- 5 676 803
- US-A- 5 833 815

## Beschreibung

Die vorliegende Erfindung betrifft ein Verfahren nach dem Oberbegriff von Anspruch 1 sowie eine Anlage nach demjenigen von Anspruch 28.

Aus der WO 00/71774 derselben Anmelderin wie vorliegende Anmeldung ist es bekannt, bei einer durch Regelung arbeitspunktstabilisierten Sputterquelle für einen reaktiven Beschichtungsprozess, an welcher plane Substrate, betrachtet parallel zur Sputterfläche, in einer Kreisbahn an der Quelle vorbei bewegt werden, den so genannten Sehnen-Effekt zu kompensieren. Unter dem Sehnen-Effekt versteht man eine ungleichmässige Verteilung der am genannten Substrat in Substratbewegungsrichtung abgelegten Materialmenge. Diese rührt im Wesentlichen daher, dass aufgrund der Kreisbahn einerseits, der planen Ausbildung der Substrate andererseits, die unterschiedlichen Substratbereiche betrachtet parallel zur Sputterfläche unterschiedliche Abstands- und Winkelverhältnisse zur Sputterfläche durchfahren. Die daraus sich ergebende in Bewegungsrichtung der Substrate unterschiedliche Beschichtungsrate an den Substraten wird dadurch kompensiert, dass synchron mit der Substratbewegung über die Sputterfläche, die Behandlungsatmosphäre nach einem gegebenen Profil moduliert wird.

Im Weiteren ist Magnetron-Sputtern bekannt. Dabei wird über der Sputterfläche eine oder mehrere bevorzugt in sich geschlossene Schleifen eines tunnelförmig aus der Sputterfläche aus- und in diese wieder eintretendes Magnetfeldes erzeugt. Aufgrund des bekannten Elektronenfallen-Effektes dieses Magnetron-Magnetfeldes in Wechselwirkung mit dem angelegten elektrischen Feld, ergibt sich im Bereich des tunnelförmigen Magnetron-Magnetfeld-Musters eine erhöhte Plasmadichte, welche ihrerseits in dieser Zone zu einer erhöhten Sputterrate führt. Die erzielte Sputterrate bei Magnetronsputtern ist wesentlich höher als bei nicht Magnetfeld-unterstütztem Sputtern. Weil sich aber entlang des Magnetron-Magnetfeld-Musters eine erhöhte Sputterrate ergibt, resultiert in der Sputterfläche in dieser Zone ein Sputtererosionsgraben, als so genannter "race track" bekannt, welcher dazu führt, dass das Sputtertarget-Material nur schlecht ausgenützt wird.

Primär aus diesem Grund ist man bekanntlich dazu übergegangen, das Magnetron-Magnetfeld-Muster, während des Betriebes der Quelle, über der Sputterfläche zu bewegen und dadurch den erhöhten Sputterabtrag im Bereich des genannten Musters möglichst über die gesamte Sputterfläche zeitlich zu verteilen. Dabei wird zusätzlich erreicht, dass, bei reaktivem Magnetronsputtern mit bewegtem Magnetron-Magnetfeld-Muster, eine wesentlich reduzierte Targetvergiftung, d.h. Störbeschichtung von Targetflächenbereichen mit elektrisch schlecht leitenden Verbindungen des Reaktivprozesses, erfolgt. Bei reaktiven Beschichtungsprozessen, d.h. der Herstellung von Verbindungsschichten z.B. ausgehend von einem metallischen Target unter Zugabe von reaktivem Prozessgas, z.B. von Sauerstoff für das Ablegen von Metalloxidschichten, erfolgt wegen des bewegten Magnetron-Magnetfeld-Musters eine gleichmässige, zyklische Erosion der Sputteroberfläche, wodurch die genannte Störbeschichtung z.B. mit einer Oxidschicht in massgeblichem Umfang reduziert wird. Dies führt zu einer erhöhten Prozessstabilität. Deshalb ist es meist nicht notwendig, bei reaktivem Magnetronsputtern mit bewegtem Magnetron-Magnetfeld-Muster, eine Prozessarbeitspunkts-Stabilisierung durch Regelung vorzusehen.

Üblicherweise wird die Bewegung des Magnetron-Magnetfeld-Musters entlang der Sputterfläche in einer Dimension oder in zwei Dimensionen zyklisch realisiert. So kann beispielsweise bei einem langen Rechtecktarget das eine geschlossene Schleife bildende Muster zyklisch in Längsrichtung des Targets hin und her bewegt werden. Dann ist diese Bewegung eindimensional zyklisch. Bei einer in beiden Dimensionsrichtungen mehr ausgedehnten Targetanordnung wird beispielsweise das Magnetfeld-Muster sowohl in der einen wie auch in der anderen zyklisch hin und her bewegt, was zu einer Bewegungsbahn des Magnetfeld-Musters entlang der Sputterfläche entsprechend Lissajous-Figuren führt. Die zyklische Magnetfeldmuster-Bewegung wird dabei insbesondere bei Rundtargets meistens durch eine Rotationsbewegung, sei dies eine umlaufende oder eine Pendel-Rotationsbewegung, realisiert bezüglich einer auf der Sputterfläche senkrecht stehenden Achse. Dabei ist ohne weiteres ersichtlich, dass bezüglich dieser Achse das Magnetfeld-Muster nicht kreisförmig sein darf.

Bekannt sind rotierend bewegte Magnetfeld-Muster, die einfach spiegelsymmetrisch sind zu einer Achse in einer Ebene parallel zur Sputterfläche. Solche Magnetfeld-Muster sind z.B. herzförmig, apfelförmig, nierenförmig etc., wie sich beispielsweise aus der US 4 995 958, der US 5 252 194, der US 6 024 843, der US 6 402 903 ergibt, oder haben eine doppelt spiegelsymmetrische Form, beispielsweise die Form einer "8", z.B. gemäss der US 6 258 217, also spiegelsymmetrisch zu zwei zueinander senkrechten Achsen in besagter Ebene.

Im Weiteren ist es bekannt, die zu beschichtenden Substrate, während des Beschichtungsvorganges, entlang der Sputterfläche mit dem bewegten Magnetron-Magnetfeld-Muster zu bewegen. Dies insbesondere bei sogenannten Batch-Anlagen, bei denen mehrere, ja eine Vielzahl von Substraten während eines Anlagenbeschichtungszyklusses beschichtet werden.

Die Anforderung an die lokale Verteilung der Beschichtungsdicke bzw., bei Reaktiv-Prozessen, an die Verteilung des abgesputterten Materials entlang der Substratfläche ist in vielen Fällen sehr hoch. Bei optischen Beschichtungen, wie sie z.B. an Komponenten für Projektionsdisplays Anwendung finden, müssen beschichtete Substrate typischerweise eine Schichtdickenverteilung haben, die höchstens 1 % von der mittleren Schichtdicke abweicht und dies betrachtet über Flächen von mindestens 1000 cm², um eine ökonomische Herstellung von Beschichtungen bestehend aus nur wenigen Schichten bis zu typischerweise 50 Schichten zu gewährleisten. Bei Verwendung so beschichteter Substrate für die optische Datenübertragung werden Schichtdickenabweichungen von höchstens 0,01 % bezüglich der mittleren Schichtdicke gefordert, dies über Flächen von mindestens 10 cm². Im letzten Fall werden an solchen Substraten häufig viele, bis über 100, Einzelschichten abgelegt, bei Prozesszeiten zwischen 12 und 50 h.

Grundsätzlich geht es darum, bei Einsatz einer Magnetronquelle mit Sputterfläche, woran ein Magnetron-Magnetfeld-Muster entlang der Sputterfläche zyklisch bewegt wird und das Substrat beabstandet von und über der Sputterfläche bewegt wird, möglichst grosse Substratflächen mit möglichst kleinen Schwankungen der Schichtdicke - bei reaktiven Beschichtungsprozessen der abgelegten Menge abgesputterten Materials - entlang der Substratfläche zu erzielen. Wenn wir in diesem Zusammenhang von "der beschichteten Substratfläche" sprechen, meinen wir die Gesamtheit solcher Flächen mehrerer Batch-behandelter kleiner Substrate oder die Fläche eines grossen Substrates.

Wir sprechen im Folgenden von der Verteilung der Schichtdicke und verstehen darunter für reaktive Prozesse die Verteilung der Menge abgesputterten Materials an der Substratfläche, welche bei Reaktivprozessen nicht zwingend mit der Schichtdicke linear zusammenhängen muss.

Um beim Einsatz runder Magnetronquellen mit Substratbewegungen genannter Art eine akzeptable Schichtdickenverteilung zu erreichen, werden heute zwischen der Bewegungsbahn der Substrate und der Sputterfläche statische, die Verteilung des Materialflusses zwischen Sputterfläche und Substrat beeinflussende Bauteile, sogenannte Aperturblenden oder "Shaper Blenden", eingesetzt. Üblicherweise wird dabei, kombiniert mit den kreisscheibenförmigen Sputterflächen, wie erwähnt wurde, das Magnetfeld-Muster bezüglich einer Achse senkrecht zur Sputterfläche durch Rotation um diese Achse zyklisch entlang der Sputterfläche bewegt.

Das Vorsehen derartiger Bauteile, wie von Shaper Blenden, ermöglicht wohl, Schichtdickenverteilungen auf dem bewegten Substrat mit Abweichungen vom Mittelwert der Schichtdicke von weniger als 1 % zu erreichen, aber nur unter Inkaufnahme des wesentlichen Nachteils, dass durch solche Bauteile wesentliche Mengen von gesputtertem Material vor Erreichen des Substrates ausgeblendet werden, womit bei gleich bleibender Sputterrate die Beschichtungsrate erheblich vermindert wird. Diese Bauteile, welche oftmals den jeweiligen Sputterquellen und Substratbewegungen angepasst werden müssen, und bei jeder Modifikation, insbesondere des Magnetron-Magnetfeld-Musters und seiner Bewegung, neu hergestellt und mit Hilfe von Iterationsschritten optimiert werden müssen, werden während des Beschichtungsvorganges selber störbeschichtet. Aufgrund der starken Erwärmung solcher Bauteile im Prozessraum ergeben sich daran Schichtspannungen, welche z.B. gemeinsam mit thermisch bedingten Formveränderungen wie Verbiegungen solcher Bauteile, dazu führen, dass die erwähnte Störbeschichtung abplatzt und durch Ablagerungen auf dem Substrat zu Beschichtungsdefekten führt.

In der US 5 833 815 wird u.a. erläutert, es sei bekannt gewesen, die Gleichförmigkeit der Schichtdicke an einem Substrat durch Variation der elektrischen Leistung am Magnetron zu verbessern, entsprechend Variationen der relativen Geschwindigkeit von Substrat und Magnet-Kreis des Magnetrons.

Es ist Aufgabe der vorliegenden Erfindung, ein Herstellungsverfahren für Magnetron-sputterbeschichtete Substrate eingangs genannter Art vorzuschlagen bzw. eine hierfür ausgelegte Anlage, woran Substrate mit wesentlich verbesserter Verteilung von abgesputtertem Material abgelegt entlang der sputterbeschichteten Fläche resultieren unter Einsatz wesentlich reduzierter Materialfluss-Ausblendung und verglichen mir der bisher erzielbaren Verteilung bei derart reduzierter Ausblendung. Dies wird bei einem Herstellungsverfahren eingangs genannter Art dadurch erreicht, dass man, gemäss Wortlaut des Kennzeichens von Anspruch 1, mit der zyklischen Bewegung des Magnetfeld-Musters phasenverriegelt, die pro Zeiteinheit auf das Substrat abgelegte Materialmenge zyklisch ändert.

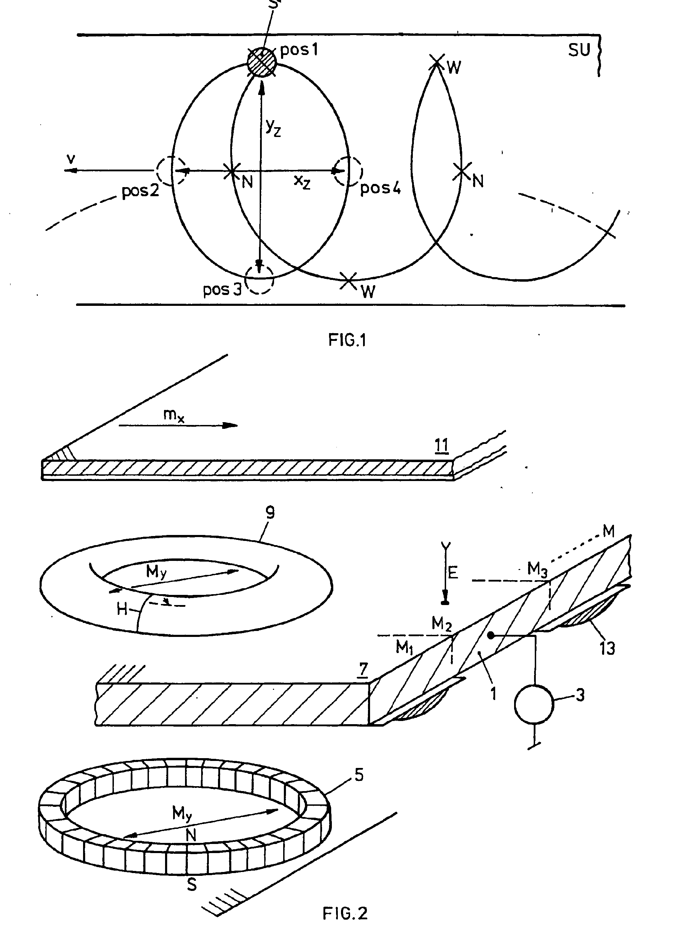

Damit die vorliegende Erfindung bereits hier verständlich wird, soll ihr Prinzip an dieser Stelle anhand von Figur 1 erläutert werden.

In Fig. 1 stellt die schraffierte Fläche S einen Ort an der Sputterfläche einer Magnetron-Sputterquelle dar, an welchem maximale Sputterrate vorherrscht. Ein solcher Ort S entspricht mithin einem Ausschnitt des Bereiches des Magnetron-Magnetfeld-Musters. Da anhand von Fig. 1 die auftretenden und erfindungsgemäss erkannten und berücksichtigten Phänomene nur heuristisch erläutert werden sollen, sei als repräsentativ für die erhöhte Sputterrate im Bereich des Magnetron-Magnetfeld-Musters nur dieser Ort S betrachtet. Durch die hier zweidimensionale zyklische Bewegung, eine zyklische Bewegung y_{z}, und, rechtwinklig dazu, eine zyklische Bewegung x_{z}, werde, wie beispielsweise gezeigt, eine ellipsenförmige Bewegungsbahn realisiert, entlang welcher der Ort S über die Sputterfläche streicht.

Über und entlang der Sputterfläche mit dem zweidimensional zyklisch bewegten Ort S laufe, mit gleichförmiger Geschwindigkeit v, ein Substrat SU. Nimmt man an, dass der Ort S jeweils von einer Position pos.m zur nächsten pos.m+1 - wie in Fig. 1 eingetragen - gleich lang braucht, so ergeben sich auf dem Substrat SU die mit X bezeichneten Lagen des Ortes S. Es ist ohne weiteres ersichtlich, dass auf dem Substrat SU eine Zykloide durchlaufen wird.

Damit ist weiter ersichtlich, dass der Ort S länger in den Wendepunktbereichen um X_{W} verweilt als in den Nulldurchgangbereichen X_{N}. Dies hat zur Folge, dass in den Peripherie- bzw. Randbereichen des Substrates SU eine grössere Materialmenge des von der Sputterfläche freigesetzten Materials abgelegt wird als im Zentralbereich.

Wendet man nun die vorliegende Erfindung auf die in Fig. 1 heuristisch dargestellten Verhältnisse an und verändert zyklisch und phasenverriegelt mit der zyklischen Bewegung von S die pro Zeiteinheit auf das Substrat abgelegte Materialmenge so, dass sie immer dann, wenn der Ort S an den Bereichen X_{W} liegt, verringert und immer dann, wenn der Ort S an den Bereichen X_{N} vorbeistreift, erhöht wird, gelingt es, die inhomogene Verteilung auf dem Substrat SU abgelegten Materials in y-Richtung zu homogenisieren bzw. gewünschte Verteilungsverhältnisse einzustellen.

In einer bevorzugten Ausführungsform des erfindungsgemässen Herstellungsverfahrens wird die zyklische Bewegung des Magnetron-Magnetfeld-Musters zweidimensional, bevorzugt durch eine pendelnde Rotationsbewegung oder eine umlaufende Rotationsbewegung um eine zur Sputterfläche senkrechte Achse realisiert. Es ist aber durchaus möglich, die zweidimensional zyklische Bewegung durch jeweilig zyklische Bewegungen je entlang einer Achse in der Sputterflächenebene zu realisieren, im Sinne der Realisation von Lissajous-Figuren.

Im Weiteren braucht die zyklische Bewegung des Magnetfeld-Musters keinesfalls zwingend zweidimensional zu sein. Wird beispielsweise an einem Langtarget das Magnetfeld-Muster nur in Längsausdehnung der Sputterfläche am Langtarget zyklisch bewegt und das Substrat senkrecht zu dieser Richtung, ergeben sich am Substrat die besprochenen Inhomogenitäten der Schichtdickenverteilung in Richtung der Target-Längsausdehnung, die erfindungsgemäss durch zyklische Veränderung der Sputterrate, phasenverriegelt mit der zyklischen Bewegung des Magnetfeld-Musters, kompensiert werden können.

Obwohl es durchaus möglich ist, die zyklische Veränderung der auf das Substrat abgelegten Materialmenge entlang der Sputterfläche lokal zu realisieren, wird in einer weitaus bevorzugten Ausführungsform vorgeschlagen, dass die abgelegte Materialmenge phasenverriegelt mit der zyklischen Bewegung des Magnetfeld-Musters gleichzeitig an der gesamten Sputterfläche verändert wird.

### Definition:

Wir verstehen unter zwei miteinander phasenverriegelten zyklischen Signalen zwei periodische Signale, die jeweils nach einer festen Anzahl Perioden eines der Signale wieder in vorgegebener Phasenrelation zueinander sind. Betrachtet in einem gegebenen Zeitfenster unterscheiden sich ihre Frequenzen f₁ und f₂ durch einen einer rationalen Zahl entsprechenden Faktor.

In einer höchst vorteilhaften Weise wird über der gesamten Sputterfläche die abgelegte Materialmenge gleichzeitig dadurch verändert, dass die Sputterleistung verändert wird.

Anstelle oder ergänzend zum Verändern der abgelegten Materialmenge mittels Veränderung der Sputterleistung kann die erwähnte Materialmenge, lokal oder wiederum über der ganzen Sputterfläche, durch Verändern des Reaktivgasflusses und/oder durch Verändern des Arbeitsgasflusses, wie beispielsweise des Argonflusses in den Prozessraum, verändert werden.

Im weiteren kann und ist bevorzugterweise die Sputterfläche einheitlich aus einem einzigen zu sputternden Material wie aus einem Metall, einer Metalllegierung oder einer MetallVerbindung, kann aber, durch Einsatz eines mehrteiligen Targets, Flächenabschnitte unterschiedlicher zu sputternden Materialien haben.

Betrachtet man wiederum Fig. 1, so ist, weiterhin heuristisch, zu erkennen, dass die abgelegte Materialmenge dann ein Minimum haben sollte, wenn der Ort S am Substrat SU die Positionen X_{W} einnimmt. Daraus ergibt sich verständlich, dass in einer weiteren bevorzugten Ausführungsform die phasenverriegelte zyklische Veränderung der Materialmenge mit einem Verlauf über der Zeit realisiert wird, dessen Frequenzspektrum eine dominante Spektrallinie bei der doppelten Frequenz bezüglich der Frequenz der zyklischen Magnetfeldmusterbewegung hat.

In einer weiteren bevorzugten Ausführungsform wird vorgeschlagen, dass der erwähnte Verlauf, hinzukommend, eine weitere dominante Spektrallinie bei der Frequenz der zyklischen Magnetfeldmusterbewegung hat. Dies ist insbesondere dann angezeigt, wenn nicht, wie in Fig. 1 dargestellt, das Substrat SU linear über die Sputterfläche bewegt wird, in Aufsicht auf die Sputterfläche betrachtet, sondern, in ebensolcher Aufsicht und wie in Fig. 1 gestrichelt eingetragen, in einer gekrümmten Bahn, vorzugsweise in einer Kreisbahn mit Krümmungszentrum ausserhalb der Sputterfläche.

Dabei ist grundsätzlich bei einer zweidimensional zyklischen Bewegung des Magnetron-Magnetfeld-Musters diejenige Bewegungskomponente massgeblich, welche senkrecht zur Bewegungsrichtung des Substrates ist, wiederum betrachtet in Aufsicht gegen die Sputterfläche. Unterscheiden sich die zyklischen Bewegungen des Magnetfeldes mit Blick auf Fig. 1 in der y- und in der x-Achse betrachtet, und erfolgt die Bewegung des Substrates mit einer Komponente in x-Richtung, so ist die zyklische Magnetfeldmusterbewegung in y-Richtung für die Phasenverriegelung mit der zyklischen Änderung der Sputterrate massgeblich.

In einer weiteren bevorzugten Ausführungsform der vorliegenden Erfindung wird das Magnetron-Magnetfeld-Muster zu einer Achse in einer Ebene, die parallel zur Sputterfläche ist, spiegelsymmetrisch oder zu zwei auf einander senkrechten derartigen Achsen spiegelsymmetrisch ausgebildet.

In einer weiteren bevorzugten Ausführungsform, nämlich für Reaktiv-Magnetronsputterbeschichten, wird in den Prozessraum zwischen Sputterfläche und Substrat ein Reaktivgas vorgesehen.

Obwohl keinesfalls zwingend, wird weiter bevorzugt eine kreisförmige Sputterfläche eingesetzt, was den Gesamtaufbau der Magnetronquelle vereinfacht.

In einer weiteren bevorzugten Ausführungsform der vorliegenden Erfindung werden zwischen Sputterfläche und Substrat keine die Materialflussverteilung beeinflussenden Bauteile vorgesehen im Sinne der erwähnten Aperturblenden.

Bevorzugt wird der Verlauf der phasenverriegelten, zyklischen Veränderung der auf das Substrat abgelegten Materialmenge in Abhängigkeit von Relativbewegung zwischen Substrat und Sputterfläche und/oder in Abhängigkeit von der Form des Magnetfeld-Musters und/oder in Abhängigkeit von der zyklischen Magnetfeldmusterbewegung gewählt.

Während der Lebensdauer des die Sputterfläche definierenden Quellentargets verändert sich, aufgrund des Sputterabtrages, die Geometrie der Sputterfläche. Dies wiederum ergibt eine sich während der Lebensdauer des Targets ändernde Verteilung während eines Zyklus der Magnetfeldmusterbewegung von der Sputterfläche abgesputterten Materials und damit eine Veränderung der Verteilung der dabei auf die Substratfläche aufgetragenen Materialmenge. Eine solche Änderung der Sputtercharakteristik an der Quelle selber kann durch Vorsehen statischer Bauteile wie der erwähnten Aperturblenden nicht auskorrigiert werden. Hingegen eröffnet die vorliegende Erfindung durchaus die Möglichkeit, auch solche Phänomene bezüglich geforderter Schichtdickenverteilung am Substrat aufzufangen, indem gemäss einer weiteren bevorzugten Ausführungsform der Erfindung der Verlauf der phasenverriegelten zyklischen Veränderung in der Zeit geändert wird. Eine solche zeitliche Veränderung des Verlaufs der phasenverriegelten zyklischen Veränderung, beispielsweise dessen Amplitude und/oder Kurvenform, kann durchaus gesteuert und nach Erfahrungswerten bei einem gegebenen Prozess erfolgen. In einer weiteren bevorzugten Ausführungsform erfolgt dies aber dadurch, dass man die momentan am Substrat abgelegte Materialmengenverteilung als gemessene Regelgrösse misst, diese gemessene Regelgrösse mit einer Sollverteilung vergleicht und nach Massgabe des Vergleichesresultates, nämlich der Regeldifferenz, den Verlauf der phasenverriegelten zyklischen Veränderung als Stellgrösse, in einem Regelkreis für die Materialmengenverteilung, stellt. Dadurch wird es möglich, sich während des Betriebes ergebende Materialverteilungsverschiebungen automatisch aufzufangen. In einer weiteren weitaus bevorzugten Ausführungsform der Erfindung wird das Substrat mehrere Male über die Sputterfläche bewegt. Dies erfolgt bevorzugterweise, indem man das Substrat zyklisch über der Sputterfläche führt, sei dies in einer Bewegungsrichtung oder hin und her.

Bevorzugt wird das Substrat, bei Ansicht gegen die Sputterfläche hin, linear bewegt. Dabei kann es in einer ersten weiteren bevorzugten Art in einer Ebene parallel zur Sputterfläche bewegt werden oder in einer weiteren bevorzugten Art, indem man das Substrat zusätzlich, in Ansicht parallel zur Sputterfläche, nichtlinear, dabei vorzugsweise entlang einer Kreisbahn, bewegt.

Wird das Substrat in Ansicht gegen die Sputterfläche hin linear bewegt, dann wird bevorzugterweise und wie oben ausgeführt jedenfalls die phasenverriegelte zyklische Veränderung der Materialmenge mit einem Verlauf über der Zeit durchgeführt, dessen Frequenzspektrum eine dominante Spektrallinie bei der doppelten Frequenz bezüglich der Frequenz der zyklischen Magnetfeldmusterbewegung hat. Dies sowohl, wenn das Substrat in einer Ebene parallel zur Sputterfläche bewegt wird, wie auch, wenn das Substrat, in Ansicht parallel zur Sputterfläche, nichtlinear, dabei insbesondere entlang einer Kreisbahn, bewegt wird.

Wird nun das Substrat, in Ansicht parallel zur Sputterfläche, nichtlinear, bevorzugt entlang einer Kreisbahn, bewegt, so kann es angezeigt sein, zusätzlich zur erwähnten, mit der zyklischen Bewegung des Magnetfeldmusters phasenverriegelten Veränderung der auf das Substrat abgelegten Materialmenge, letztere auch synchron mit der Substratbewegung zu verändern, wie dies ausführlich in der WO 00/71774 erläutert ist.

Erfolgt die Substratbewegung, in Ansicht gegen die Sputterfläche hin nicht linear, dabei insbesondere bevorzugt entlang einer Kreisbahn mit Kreismittelpunkt ausserhalb der Sputterfläche, so wird der Verlauf der zyklischen Veränderung der Materialmenge über der Zeit mit einer dominanten Frequenzkomponente sowohl bei der doppelten wie auch bei der gleichen Frequenz wie die Frequenz der zyklischen Musterbewegung ausgebildet. Obwohl es im Weiteren, gemäss vorliegender Erfindung, durchaus möglich ist, gezielt erwünschte Schichtdicken-Verteilungsprofile an den Substraten herzustellen, wird in weitaus bevorzugter Art und Weise an den Substraten eine optimiert homogene Schichtdickenverteilung realisiert. Dabei werden, weiter bevorzugt, plane Magnetron-sputterbeschichtete Substrate hergestellt.

Eine Magnetron-Sputterbeschichtungsanlage gemäss vorliegender Erfindung mit einer Magnetronquelle und einer unterhalb eines Sputtertargets, in einer Ebene parallel zur Sputterfläche des Sputtertargets zyklisch angetriebenen Magnetanordnung sowie mit einer Substrattransportanordnung, mittels welcher ein Substrat über der Sputterfläche bewegt wird, hat eine Modulationsanordnung für die pro Zeiteinheit von der Quelle abgesputterte Materialmenge, die diese Menge zyklisch und phasenverriegelt mit der zyklischen Bewegung der Magnetanordnung moduliert.

Bevorzugte Ausführungsformen der Magnetron-Sputterbeschichtungsanlage gemäss vorliegender Erfindung sind in den Ansprüchen 29 bis 36 spezifiziert.

Die Erfindung wird nun beispielsweise anhand von Figuren erläutert. Diese zeigen:
- Fig. 1: schematisch und ohne Anspruch auf physikalische Exaktheit, die als Basis für die vorliegende Erfindung erkannten Verhältnisse bei einer Magnetronsputterquelle mit bewegtem Magnetron-Magnetfeldmuster und bewegtem Substrat;
- Fig. 2: schematisch und vereinfacht, eine erste Ausführungsform des erfindungsgemässen Verfahrens bzw. einer erfindungsgemässen Anlage;
- Fig. 3: in einer Darstellung analog zu derjenigen von Fig. 2, eine heute bevorzugte Ausführungsform des erfindungsgemässen Verfahrens bzw. einer erfindungsgemässen Anlage;
- Fig. 4: in Aufsicht, eine im Rahmen der Erfindung bevorzugt eingesetzte Rundmagnetronquelle mit verschiedenen diesbezüglichen Bewegungsbahnen eines Substrates als Basis für die Diskussion der bahnspezifisch optimierten Auslegung der vorliegenden Erfindung;
- Fig. 5: die Quelle gemäss Fig. 4, schematisch in Querschnittsdarstellung;
- Fig. 6: schematisch und höchst vereinfacht, eine Inline-Magnetron-Sputterbeschichtungsanlage, woran der in Fig. 4 dargestellte eine Bewegungstyp des Substrates bezüglich der Quelle realisiert ist;
- Fig. 7: wiederum schematisch und höchst vereinfacht, eine Anlage, woran Substrate auf einer Kreisbahn an der Quelle vorbei bewegt werden gemäss dem in Fig. 4 dargestellten zweiten Bewegungstyp;
- Fig. 8 und 9: sich am Substrat zu seiner Bewegungsrichtung ergebende Schichtdickenverteilungen, ohne jegliche Kompensationsmassnahme (a), mit in bekannter Art und Weise vorgesehener Aperturblende (b), und (c) realisiert mit der vorliegenden Erfindung, und
- Fig. 10: ein weiterer Typ der Relativbewegung zwischen Substrat und Quelle.

In Fig. 2 ist vereinfacht und schematisch eine erste Ausführungsform einer erfindungsgemässen Magnetron-Sputterbeschichtungsanlage dargestellt bzw. eine erste Variante des Herstellungsverfahrens gemäss vorliegender Erfindung.

Ein Target 1 - vorzugsweise einteilig aus Material M oder ggf. zwei- oder mehrteilig (gestrichelt) aus jeweils den Materialien M₁, M₂, ... - einer nicht in Details dargestellten Magnetronsputterquelle wird über eine elektrische Generatoranordnung 3 bezüglich einer nicht dargestellten Anode der Quelle elektrisch gespiesen, üblicherweise mit DC, ggf. aber auch mit DC und AC oder nur mit AC, dabei bis in den Hochfrequenz-Bereich RF. Dadurch wird das in Fig. 2 schematisch eingetragene elektrische Feld E in bekannter Art und Weise erzeugt. Unterhalb des Targets 1 ist eine Magnetanordnung 5 vorgesehen, deren Magnetfeld durch das Target 1 durchgreift mit aus der Sputterfläche 7 aus- und in diese wieder eintretenden Feldlinien. Die Feldlinien H bilden ein Feldmuster 9 in Form einer geschlossenen, tunnelförmigen Schleife. Das Magnetron-Magnetfeldmuster 9 in bekannter Art und Weise führt gemeinsam mit dem elektrischen Feld zu einer ausgeprägten Plasmadichteerhöhung im Bereich des Magnetfeldmusters 9 mit der damit dort resultierenden Erhöhung der Sputterrate. Die Magnetanordnung 5 erzeugt, wie erwähnt, in den überaus meisten Fällen das Magnetfeldmuster 9 an der Sputterfläche 7 als in sich geschlossene Schleife.

Wie in Fig. 2 schematisch weiter dargestellt, wird mit hier nicht dargestellten Antriebsmitteln die Magnetanordnung 5 in mindestens einer Richtung - gemäss Fig. 1 in y-Richtung - zyklisch entlang des Targets 1 hin und her bewegt, wie dies mit dem Doppelpfeil M_{y} dargestellt ist. Mit der Magnetanordnung 5 unterhalb des Targets 1 wandert das Magnetfeldmuster 9 gleichermassen entlang der Sputterfläche 7.

Ein Substrat 11 wird, beabstandet von der Sputterfläche 7, an dieser vorbei bewegt, dabei mindestens mit einer Bewegungskomponente mₓ, welche zur Bewegungsrichtung M_{y} der Magnetanordnung 5 und damit des Magnetfeldmusters 9 senkrecht steht. Gemäss dem grundsätzlichen Prinzip der vorliegenden Erfindung wird die Rate von der Sputterfläche 7 abgesputterten Materials phasenverriegelt mit der zyklischen Bewegung M_{y} von Magnetanordnung 5 bzw. Magnetfeldmuster 9 zyklisch verändert, d.h. moduliert. Dies kann wie bei der Ausführungsform gemäss Fig. 2 dadurch realisiert werden, dass zwischen Magnetanordnung 5 und Sputterfläche 7 in Bewegungsrichtung M_{y} der Magnetanordnung 5, der magnetische Widerstand des Durchgriffes zwischen Magnetanordnung 5 und Sputterfläche 7 lokal verändert bzw. moduliert wird. Wie schematisch in Fig. 2 dargestellt, kann dies beispielsweise durch Vorsehen den magnetischen Widerstand des Targets 1 lokal erhöhender Materialeinlage 13 realisiert werden, wodurch entlang der Sputterfläche 7, lokal, die Feldstärke H des Magnetfeldmusters 9 moduliert wird und damit lokal die Plasmadichte und mithin die Sputterrate. Dem Fachmann eröffnen sich weitere Möglichkeiten, lokal und phasenverriegelt mit der zyklischen Bewegung der Magnetanordnung 5 bzw. des Magnetfeldmusters 9, die Sputterrate zu modulieren, nämlich beispielsweise durch Vorsehen von Elektromagneten an der Magnetanordnung 5, durch mechanische Verschiebung einzelner Magnete der Magnetanordnung 5, durch Modulation des Abstandes zwischen Magnetanordnung 5 und Target 1 etc. Grundsätzlich wird beim Vorgehen gemäss Fig. 2 die Sputterrate entlang der Sputterfläche 7 somit lokal moduliert.

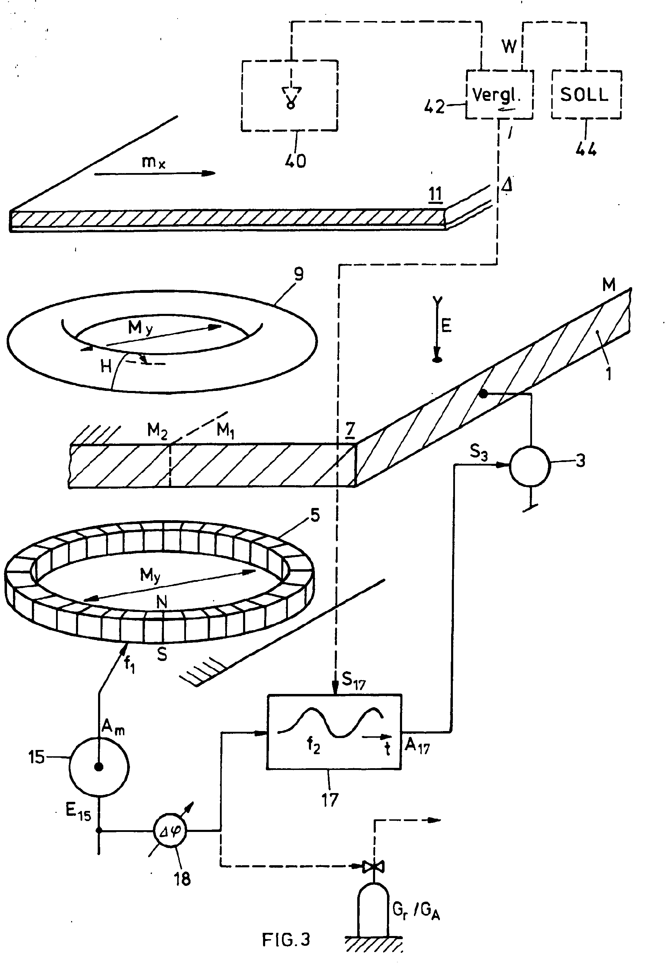

In Fig. 3 ist in einer Darstellung analog zu derjenigen von Fig. 2 eine weitere grundsätzliche Ausführungsform der vorliegenden Erfindung dargestellt, welche, mindestens heute, klar bevorzugt eingesetzt wird. Bereits anhand von Fig. 2 beschriebene Vorkehrungen und Teile sind in Fig. 3 mit denselben Bezugszeichen referenziert und werden nicht nochmals beschrieben. Wie in Fig. 3 gezeichnet, wird die Bewegung M_{y} der Magnetanordnung 5 mittels eines Antriebes 15 realisiert. Die elektrische Generatoranordnung 3 für das Target 1 hat einen Steuer- d.h. Modulationseingang S₃. Eine Verlaufvorgabeeinheit 17, deren Ausgang A₁₇ mit dem Steuereingang S₃ wirkverbunden ist, erzeugt ein zyklisches, d.h. periodisches, Modulationssignal für die Generatoranordnung 3 mit vorgegebenem bzw. vorgebbaren Verlauf. Bezeichnet man die Zyklusfrequenz der Bewegung M_{y} von Magnetanordnung 5 und damit von Magnetfeldmuster 9 mit f₁, so ist die Frequenz f₂ des periodischen Steuersignals, das an der Einheit 17 erzeugt wird, n·f₁ gewählt, mit n als rationale Zahl. Das periodische, dem Steuereingang S₃ zugeführte Steuersignal der Frequenz f₂ ist mit der zyklischen Bewegung M_{y} der Magnetanordnung 5 mit der 5 Frequenz f₁ phasenverriegelt, d.h. die Phasenlage des Steuersignals bezüglich der zyklischen Bewegung m_{y} ist jeweils nach einer durch n gegebenen Anzahl Perioden des zyklischen Steuersignals gleich. Hierzu ist ein Eingang der Einheit 17 mit dem mechanischen Ausgang Am des Antriebes 15 oder, und dies bevorzugt, mit dem elektrischen Eingang E₁₅ des Antriebs 15 wirkverbunden, wie schematisch dargestellt bevorzugterweise über eine ggf. einstellbare Phasenvorgabeeinheit 18. An der Einheit 17 sind vorzugsweise weitere Eingänge S₁₇ vorgesehen, an welchen Grössen des zyklischen Steuersignal-Verlaufs, insbesondere Frequenz f₂, Kurvenform mit Amplitude etc. einstellbar sind.

Wie in Fig. 3 weiter gestrichelt und schematisch dargestellt, kann anstelle oder zusätzlich zur bevorzugten Veränderung der Sputterleistung über die Generatoranordnung 3, phasenverriegelt über Einheit 18, die Zufuhr von Reaktivgas Gᵣ und/oder eines Arbeitsgases G_{A} wie von Argon in den Reaktionsraum zwischen Sputterfläche 7 und Substrat 11 verändert werden. Die Veränderung kann dabei grossflächig über die ganze Sputterfläche 7 erfolgen, oder lokal entlang vorgegebenen Bereichen der Sputterfläche 7.

Im Unterschied zur Ausführungsform gemäss Fig. 2 wird aber bei der Ausführungsform gemäss Fig. 3, die heute bevorzugt ist, nicht lokal die Sputterrate an der Sputterfläche 7 phasenverriegelt mit der zyklischen Bewegung der Magnetanordnung 5 verändert, sondern es wird die gesamte momentane Sputterrate an der Sputterfläche 7 phasenverriegelt mit der Magnetanordnungsbewegung M_{y} verändert bzw. moduliert.

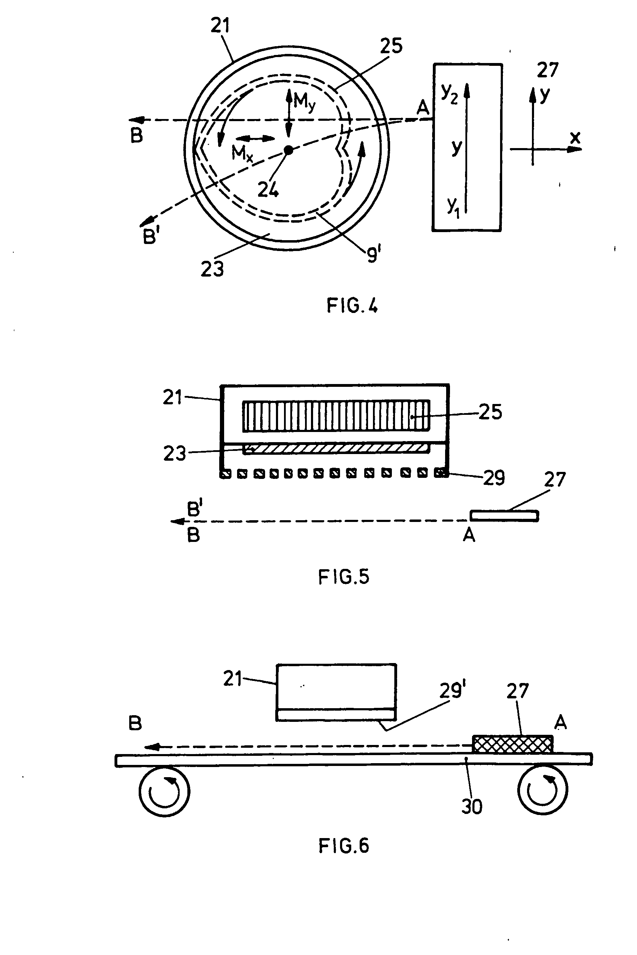

In Fig. 4 ist schematisch und in Aufsicht eine im Rahmen vorliegender Erfindung bevorzugterweise eingesetzte Rundmagnetron-Sputterquelle 21 dargestellt, deren Target 23 bzw. Sputterfläche vom Magnetfeldmuster 9' überstrichen wird. Die Magnetanordnung 25 ist in dargestellter Aufsicht spiegelsymmetrisch zu einer parallel zur Sputterfläche des Targets 23 liegenden Achse ausgebildet, wie dargestellt z.B. herzförmig. Mit 27 ist schematisch das erfindungsgemäss in x-Richtung bewegte Substrat dargestellt. Die anhand von Fig. 2 bzw. 3 erörterte zyklische Bewegung der Magnetanordnung ist hier, wie bevorzugt, als zweidimensionale zyklische Bewegung realisiert, mit den vorzugsweise jeweils mit gleicher Frequenz durchlaufenen Bewegungskomponenten M_{y} und Mₓ. Diese zyklische zweidimensional Bewegung wird bevorzugterweise und wie in Fig. 4 auch dargestellt durch Rotation der Magnetanordnung 25 um die Achse 24 realisiert.

Selbstverständlich kann ggf. anstelle einer umlaufenden Rotation eine Rotationspendelbewegung eingesetzt werden. Im Weiteren kann anstelle der dargestellten einachsspiegelsymmetrischen Magnetanordnung 25 eine andere Form der Magnetanordnung eingesetzt werden. Insbesondere kann, wie bereits eingangs erwähnt wurde, eine Zweiachsspiegelsymmetrische Magnetanordnung eingesetzt werden, beispielsweise in Form einer "8" mit Rotationsachse 24 beispielsweise im Zentrum der Form, eine nierenförmige Form etc.

In Fig. 5 ist die Rundmagnetronsputterquelle gemäss Fig. 4 schematisch im Querschnitt dargestellt, wobei bei 29 gestrichelt angedeutet ist, wo eine vorbekannte Aperturblende montiert wäre. Dabei ist aber zu betonen, dass gemäss vorliegender Erfindung ggf. höchstens eine Aperturblende eingesetzt wird, die wesentlich weniger des von der Sputterfläche abgesputterten Materials ausblendet als herkömmlicherweise eingesetzte Blenden, bzw. dass gemäss vorliegender Erfindung gar ohne Vorsehen solcher Bauteile die geforderten Schichtdickenverteilungen erzielt werden.

Das Substrat 27 wird bevorzugt mehrere Male an der Quelle 21 vorbei bewegt, sei dies in gleich bleibender Richtung, sei dies durch Hin-und-her-Bewegung.

Wie erwähnt wurde, ist die erfindungsgemäss eingesetzte Modulationskurvenform, mittels welcher, phasenverriegelt mit der Magnetanordnungs-Zyklusbewegung, die Sputterrate bzw. die jeweils auf das Substrat abgelegte Materialmenge moduliert wird, abhängig von der Form der Magnetanordnung und deren Bewegungsdynamik, weiter von der Bewegungsbahn und Dynamik der Substratbewegung. Beispielhaft sei im Folgenden auf drei Fälle eingegangen. In den Fig. 4 und 5 sind zwei dieser Fälle dargestellt, bei denen das Substrat 27 in einer Ebene parallel zur Sputterfläche des Targets 23 bewegt wird, linear gemäss der eingetragenen Bahn A-B oder nichtlinear gemäss Bahn A-B', dabei vorzugsweise auf einer Kreisbahn um ein ausserhalb der Sputterfläche des Targets 23 liegendes (nicht dargestelltes) Zentrum Z. Eine Bewegung des Substrates 27 auf einer linearen Bahn gemäss A-B ist in aller Regel bei so genannten Inline-Beschichtungsanlagen gegeben. Eine solche Inline-Beschichtungsanlage ist, schematisch und vereinfacht, ausschnittsweise in Fig. 6 dargestellt. Das Substrat 27 liegt dabei auf einem Substratträger 30 und wird wie auf einem Laufband ein oder mehrere Male, vorzugsweise letzteres, linear an der Sputterquelle 21 vorbei bewegt. Eine bei vorbekanntem Vorgehen, d.h. ohne Einsatz der Massnahmen gemäss vorliegender Erfindung, üblicherweise vorzusehende Aperturblende wäre am Ort 29' einzubauen.

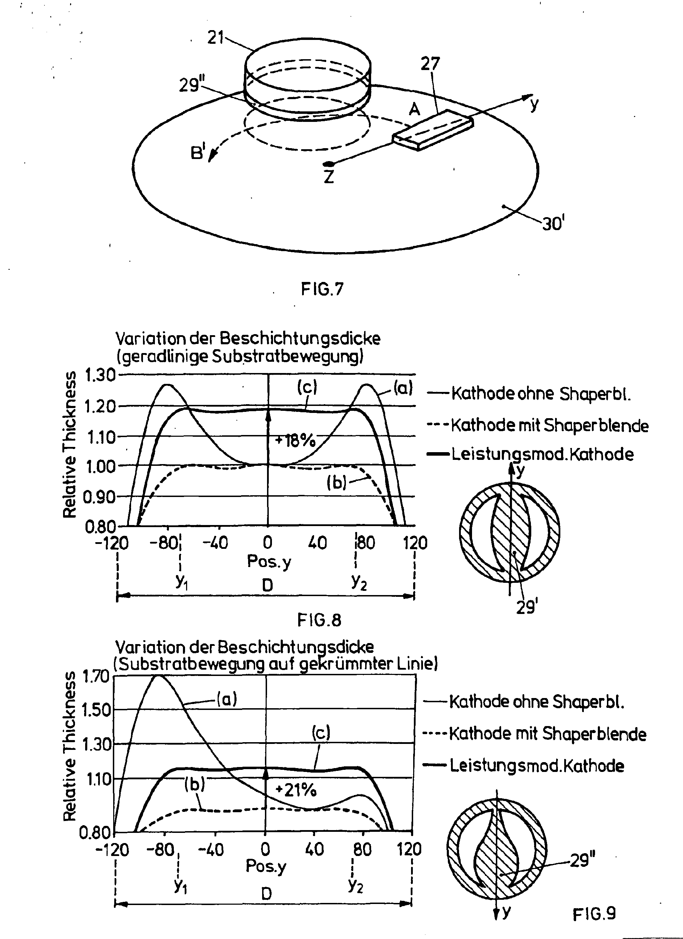

Fig. 7 zeigt schematisch wie die nichtlineare Bewegungsbahn A-B' gemäss Fig. 4 beispielsweise zustande kommt, nämlich indem das Substrat 27 auf einem scheibenförmigen oder einem domförmigen Substratträger 30' angeordnet ist, mit Rotationszentrum Z ausserhalb der Sputterfläche der Quelle 21. In Fig. 7 ist mit 29" wiederum der Ort angegeben, wo gemäss vorbekanntem Vorgehen eine Aperturblende eingebaut werden müsste.

Gemäss Fig. 4 enthält das Substrat 27 einen Bereich mit der Ausdehnung in y-Richtung von y1 bis y2, der mit einer spezifizierten Schichtdickenverteilung, meist einer möglichst homogenen Verteilung beschichtet werden soll. Gemäss vorliegender Erfindung wird mit Modulation der Sputterleistung die Sputterrate für jede Stellung der rotierenden Magnetanordnung 25 unmittelbar beeinflusst, um so durch geeignete Wahl des Modulationsverlaufes eine Homogenisierung der resultierenden Schichtdicke auf dem Substrat 27 zu erhalten, ohne Einsatz einer Aperturblende oder höchstens unter Einsatz einer Aperturblende mit wesentlich verringerter Ausblendfläche.

Wie bereits aus Fig. 1 erkenntlich, hat sich bestätigt, dass es für den Fall der linearen Bewegung A-B, aber bereits bei einer linearen Bewegungskomponente, vorteilhaft ist, die Modulationsgrundfrequenz gemäss f₂ von Fig. 3 bei doppelter Rotationsfrequenz f₁ der Magnetanordnung 25 zu wählen, wenn keine zusätzlichen Asymmetrien korrigiert werden müssen. Somit wird bevorzugterweise in diesem Fall an der Einheit 17 gemäss Fig. 3 eine Modulationskurvenform gewählt, welche bei 2f₁ in ihrem Frequenzspektrum eine überragende Spektralamplitude hat. Die Rotationsfrequenz bzw. Zyklusfrequenz gemäss f₂₅ bzw. f₁ der Magnetanordnung 25 bzw. 5 muss so hoch gewählt werden, dass während der Bewegung des Substrates 27 bzw. 11 an der Quelle vorbei die Magnetanordnung 5 bzw. 25 mehrere Zyklen durchläuft, was durch entsprechende Erhöhung der Magnetanordnungs-Zyklusfrequenz bzw. Verlangsamung der Substratbewegungsgeschwindigkeit sichergestellt wird. Typische Zyklusfrequenzen der Bewegung M_{y} gemäss Fig. 3 bzw. der Rotation gemäss Fig. 4 liegen im Hz-Bereich, also typischerweise zwischen 0,1 und 10 Hz, und die Bewegung des Substrates 27 bzw. 5 vorbei an der Sputterquelle dauert mehrere Sekunden, insbesondere, wenn das Substrat nur einmal an der Magnetron-Sputterquelle vorbeibewegt wird. Im Falle einer mehrmaligen Bewegung des Substrates vorbei an der Sputterfläche kann die Substratbewegung schneller erfolgen. Allerdings ist in diesem Fall darauf zu achten, dass der Zyklus, mit welchem das Substrat an der Sputterfläche vorbeibewegt wird, asynchron zum Zyklus der Magnetanordnungsbewegung erfolgt. Bei einem mit dem Bewegungszyklus der Magnetanordnung synchronisierten Zyklus der Substratbewegung muss ggf. eine zusätzliche, mit der Substratbewegung synchronisierte Modulation der Sputterrate eingesetzt werden.

In Fig. 8 ist der simulierte Verlauf der Schichtdickenverteilung an einem planen Substrat dargestellt, welches gemäss Fig. 4, Bewegungsbahn A-B, mehrere Male über die Sputterfläche bewegt wird. D bezeichnet dabei den Durchmesser der kreisförmigen Sputterfläche, die Positionen y₁ und y₂ die entsprechenden Positionen am Substrat 27 von Fig. 4. Die y-Richtung entspricht der y-Richtung am Substrat gemäss Fig. 4 bzw. der y-Richtung gemäss den Fig. 2 oder 3. Verlauf (a) zeigt den Schichtdickenverlauf, wenn die Sputterbeschichtungsanordnung ohne erfindungsgemässe Sputterraten-Modulation und ohne Aperturblende eingesetzt wird. Der Verlauf (b) ergibt sich, weiterhin ohne Einsatz der erfindungsgemäss eingesetzten Sputterratenmodulation, aber bei Vorsehen einer Aperturblende 29', wie sie in Fig. 8 dargestellt ist. Der Verlauf (c) zeigt das Resultat bei erfindungsgemässem Einsatz der mit der zyklischen Bewegung der Magnetanordnung phasenverriegelten zyklischen Änderung, d.h. Modulation der Sputterrate, wie sie sowohl gemäss Fig. 3 wie auch gemäss Fig. 4 realisiert ist. Es wurde ein Modulationsverlauf eingesetzt, dessen Spektrum bei der doppelten Frequenz der zyklischen Magnetanordnungsbewegung eine überragende Spektrallinie hat, spezifisch hier mit dieser Grundharmonischen. Die gemäss Fig. 8 simulierten Verläufe haben sich zwischenzeitlich in der Praxis im Wesentlichen bestätigt. Durch Weglassen der Aperturblende 29' und Einsatz der Massnahmen gemäss vorliegender Erfindung gelangt im Wesentlichen alles von der Sputterfläche freigesetzte Material auf das Substrat, was zu einer signifikant erhöhten Beschichtungsrate, mithin kürzeren Beschichtungszeiten und höherer Produktivität führt. Die Beschichtungsrate ist gemäss Fig. 8 um ca. 18 % erhöht. Dies bei gleich bleibender mittlerer elektrischer Leistung an der Magnetronquelle und anderseits, insbesondere bei Ausführung gemäss Fig. 4, bei effizienter Ausnutzung des Targetmaterials, was zu höheren Standzeiten der Beschichtungsanlage führt. Bei Einsatz einer Aperturblende kann der Verlust bezüglich Beschichtungsrate nicht einfach durch Erhöhung der angelegten elektrischen Leistung kompensiert werden, weil die maximal einsetzbare elektrische Sputterleistung am Target gewöhnlich durch die Effizienz der vorgesehenen Targetkühlung beschränkt ist.

Im Falle eines reaktiven Magnetronsputterbeschichtungsprozesses, bei welchem (nicht dargestellt) in allen Realisationsformen der vorliegenden Erfindung zwischen Magnetronsputterquelle und Substrat ein Reaktivgas vorgesehen ist, ergibt zudem eine überhöhte Quellenleistung Einbussen in der Schichtqualität. Aufgrund einer solchen überhöhten Leistung wird der Reaktionsprozess von der Sputterfläche freigesetzten Materials mit dem Reaktivgas geändert, was zu Änderungen der Stöchiometrie am Schichtmaterial führt. Dabei kann z.B. die optische Absorption aufgrund geänderter Stöchiometrie in der oder in den Schichten störend ansteigen.

Der zweite der oben erwähnten drei Substratbewegungstypen ist wie in Fig. 4 dargestellt, nichtlinear, insbesondere entlang einer Kreisbahn AB'. Die Bewegungsbahn des Substrates hat dabei, wie ohne weiteres ersichtlich, sowohl eine Bewegungskomponente Mₓ, d.h. in Richtung A-B, wie auch eine Bewegungskomponente quer dazu, entsprechend M_{y}. Es ergibt sich eine in Bezug auf die y-Ausdehnung des Substrates asymmetrische Schichtdickenverteilung auch aufgrund der y-Ausdehnung des Substrates. Dies zeigt ohne weiteres eine Betrachtung von Fig. 7. In y-Richtung versetzte Substratbereiche werden mit unterschiedlichen Geschwindigkeiten über unterschiedlich lange Bereiche der Sputterfläche bezüglich der Achse Z exzentrisch angeordneter Magnetronsputterquellen bewegt. Die den in Fig. 8 entsprechenden Resultate für diesen Fall sind in Fig. 9 dargestellt. Der Schichtdickenverlauf bei Beschichtung mit einer Anordnung, wie sie in Fig. 4 oder in Fig. 2 dargestellt ist, ohne Einsatz der erfindungsgemässen Sputterratenmodulation und ohne Einsatz einer Aperturblende ist bei (a) dargestellt. Um die stark inhomogene Verteilung (a) mit einer Aperturblende 29" zu kompensieren, muss letztere entsprechend asymmetrisch geformt sein. Der Verlauf der Beschichtung mit vorgesehener Aperturblende 29", aber ohne Einsatz der erfindungemässen Sputterratenmodulation, ist durch den Verlauf (b) dargestellt. Der Verlauf (c) zeigt die Schichtdickenverteilung bei Einsatz der erfindungsgemässen Sputterratenmodulation. Dabei wurde in Analogie zu den Betrachtungen zu Fig. 8 ein Modulationszyklusverlauf gewählt, der einerseits aufgrund der Substratbewegung in x-Richtung entsprechend Mₓ von Fig. 4 in seinem Frequenzspektrum bei der doppelten Frequenz der zyklischen Magnetanordnungsbewegung eine prädominante Spektralamplitude hat, zudem aber, um Ratenunterschiede aufgrund der unterschiedlichen Bewegungsradien der verschiedenen Substratpartien in y-Richtung gemäss Fig. 7 zu berücksichtigen, eine weitere prädominante Spektralamplitude bei der Frequenz gleich der Frequenz der zyklischen Magnetanordnungsbewegung.

Es wird ein einfach spiegelsymmetrische Magnetanordnung mit einer versetzten Rotationsachse gemäss Fig. 4 verwendet, da bei einer Zwei-Achs-symmetrischen Magnetanordnung beispielsweise in Form einer "8" bei einer Sputterratenmodulation mit prädominanter Modulationsfrequenz, die derjenigen der Magnetanordnungsbewegung entspricht, keine Asymmetrie in der Sputter- und damit Beschichtungsrate erzielt werden kann. Wird ein einfach spiegelsymmetrisches Magnetsystem gemäss Fig. 4 eingesetzt, so kann die notwendige Asymmetrie mit der Auslegung dieses Magnetsystems erreicht werden, die übrige Homogenisierung der Schichtdickenverteilung erfolgt analog zum Fall gemäss Fig. 8, d.h. bei linearer Bewegungskomponente in Richtung A-B gemäss Fig. 4, mit Hilfe der Sputterratenmodulation bei der doppelten Frequenz, bezogen auf die Frequenz der zyklischen Magnetanordnungsbewegung.

Sowohl bei einer linearen Substratbahn parallel zur Sputterfläche wie auch bei einer gekrümmten Substratbahn, weiterhin parallel zur Substratfläche, kann, wie beschrieben wurde, mit Hilfe der Sputterratenmodulation, insbesondere bevorzugt realisiert durch Sputterleistungsmodulation gemäss Fig. 3, eine sehr gute Schichtdickenverteilung erzielt werden, ohne dass Aperturblenden eingesetzt werden müssen. Damit wird eine Schichtdickenverteilungsoptimierung über einen extern variablen Prozessparameter, nämlich die elektrische Sputterleistung, ermöglicht. Wesentlich für das optimale Funktionieren der erfindungsgemäss dynamischen Schichtdickenverteilungskorrektur ist die Geschwindigkeit bzw. Änderungsrate, mit der die elektrische Leistung, welche der Quelle zugeführt wird, verändert werden kann. Mit heutigen, kommerziell erhältlichen Power-Supplies ist es ohne Weiteres möglich, die Ausgangsleistung im Kleinsignalverhalten, d.h. typischerweise ± ein oder mehrere 10 % um die statische Arbeitspunktleistung herum, mit Frequenzen bis in den Bereich von über 100 Hz ohne signifikanten Signaleinbruch zu modulieren. Damit können selbst komplexe Modulationskurvenformen mit Grundfrequenzen im Bereich von über 10 Hz und signifikanten höherspektralen Anteilen mit grosser Genauigkeit und ohne wesentliche Phasenverschiebung realisiert werden. Dies ist wichtig für eine genaue Modulationsführung und Phasenverriegelung mit der zyklischen Magnetanordnungsbewegung.

Die höhere Beschichtungsrate bzw. Sputterrate kann auch erfindungsgemäss im Falle eines reaktiven Magnetronsputterprozesses erreicht werden. Die für die Stabilität des Reaktivprozesses relevante Zeitkonstante (inhärent durch Prozess bedingt, z.B. durch Reaktivgasdruck, Sputterrate, Kammergeometrie, Vakuumpumpen etc.) liegt typischerweise im Bereich von über 100 msec. oder länger. Bei einer Zyklus- bzw. Rotationsfrequenz der Magnetanordnung 25 bzw. 5 gemäss den Fig. 4 bzw. 3 von einigen Hz liegt die relevante Zeitkonstante τ = 1/ (2 τf) für die Veränderungen der Beschichtungsrate bzw. Sputterrate deutlich unter diesen 100 msec., womit die Beeinflussung des Reaktivprozesses nur minimal ist. Mit anderen Worten ist der Reaktivprozess üblicherweise zu träge, als dass er durch die erfindungsgemäss wirksam eingesetzte Sputterratenmodulation merklich gestört würde.

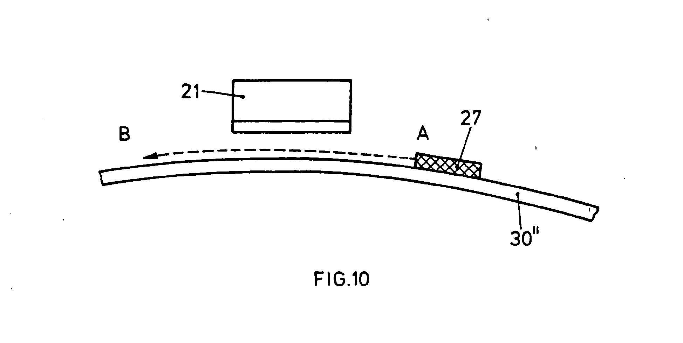

In Fig. 10 ist schematisch der dritte Fall der Substratbewegung dargestellt, wonach, möglicherweise zusätzlich zur Ausgestaltung der Bewegungsbahn, wie in Aufsicht in Fig. 4 dargestellt, die Bewegungsbahn, in Richtung parallel zur Sputterfläche der Quelle 21 betrachtet, gekrümmt, vorzugsweise entsprechend einer Kreisbahn gekrümmt ist. In diesem Fall wird nebst den mit Bezug auf die Bahnen A-B bzw. A-B' bereits erläuterten Sputterraten-Modulationsverläufen, diese phasenverriegelt mit der zyklischen Bewegung der Magnetanordnung - wie dies in der WO 00/71774 erläutert ist - die Sputterrate mit einer weiteren Modulation verändert, nun aber synchronisiert mit der Substratbewegung, um den eingangs erwähnten Sehneneffekt auszugleichen.

Die Schichtdickenverteilungsoptimierung gemäss vorliegender Erfindung und insbesondere über den extern zugreifbaren Prozessparameter "Sputterleistung" ermöglicht auch eine Anpassung an den aktuellen Erosionszustand des Targets im Sinne einer Nachführung der Modulationskurvenform an die jeweils vorherrschenden Verhältnisse. Damit kann auch die Restabhängigkeit der Schichtdickenverteilung über die Lebensdauer des Targets weitestgehend eliminiert werden. Weil die Beeinflussung der Verteilung über Veränderung bzw. Modulation der Sputterrate, insbesondere bei Modulation der Sputterleistung, praktisch verzugslos erfolgt, ist eine Verteilungsoptimierung durch In-situ-Regelung möglich. Dabei wird mit Hilfe eines geeigneten In-situ-Messsystems die momentan vorherrschende Schichtdickenverteilung erfasst, beispielsweise durch sogenanntes Breitband-Spektralmonitoring, und das Messresultat als Regelgrösse in einem Regelkreis zur Regelung der Schichtdickenverteilung eingesetzt.

Dies ist schematisch und gestrichelt in Fig. 3 dargestellt. Mit dem Schichtdickenverteilungs-in-situ-Messsystem 40 wird die momentane Schichtdickenverteilung am Substrat 11 erfasst. An einer Vergleichereinheit 42 wird die gemessene Verteilung mit einer beispielsweise in Form einer Tabelle abgespeicherten Sollverteilung von einer Sollverteilungs-Vorgabeeinheit 44 verglichen. Der Ausgang der Vergleichereinheit 42, mit der Regeldifferenz Δ, wird mit dem Steuereingang S₁₇ der Modulationsvorgabeeinheit 17 wirkverbunden und an dieser der Verlauf der Sputterratenmodulation in Funktion der am Ausgang der Vergleichereinheit 42 aufscheinenden Regeldifferenz Δ so lange gestellt, bis die gemessene Schichtdickenverteilung nicht mehr von der an Einheit 44 vorgegebenen SollVerteilung W abweicht, als dies durch die tolerierte verbleibende Regelabweichung gegeben ist.

Auch wenn schwergewichtig im Zuge der Beschreibung vorliegender Erfindung das Augenmerk darauf gerichtet wurde, an den hergestellten Substraten eine optimiert homogene Schichtdickenverteilung zu erzielen, ist es ohne Weiteres ersichtlich, dass durch entsprechende Auslegung der Sputterratenmodulation, was Grundfrequenz, Kurvenform und Phasenlage bezüglich dem Bewegungszyklus der Magnetanordnung anbelangt, andere erwünschte Schichtdickenverteilungen am Substrat realisierbar sind, betrachtet in einer Richtung quer zur Bewegungsrichtung des Substrates in Aufsicht auf die Sputterfläche.

## Patentansprüche

1. Verfahren zur Herstellung Magnetron-sputterbeschichteter Substrate, bei dem
• an einer Magnetronquelle mit Sputterfläche (7) ein Magnetron-Magnetfeld-Muster (9, 9') entlang der Sputterfläche zyklisch bewegt wird;
• das Substrat beabstandet von und über der Sputterfläche bewegt (15) wird,
**dadurch gekennzeichnet, dass** man, mit der zyklischen (f₁) Bewegung des Magnetfeldmusters phasenverriegelt (Δϕ), die pro Zeiteinheit auf das Substrat abgelegte Materialmenge zyklisch ändert (3).

2. Verfahren nach Anspruch 1, **dadurch gekennzeichnet, dass** man die zyklische Bewegung des Magnetfeldmusters zweidimensional (Mₓ, M_{y}) ausführt, vorzugsweise durch eine Rotations-Pendel- oder -Umlaufbewegung bezüglich einer zur Sputterfläche senkrechten Achse (24).

3. Verfahren nach einem der Ansprüche 1 oder 2, **dadurch gekennzeichnet, dass** die abgelegte Materialmenge gleichzeitig über der gesamten Sputterfläche zyklisch verändert (3) wird.

4. Verfahren nach einem der Ansprüche 1 bis 3, **dadurch gekennzeichnet, dass** die abgelegte Materialmenge durch Veränderung eines Reaktivgasflusses (G_{R}) in den Raum zwischen Sputterfläche (7) und Substrat (11, 27) verändert wird.

5. Verfahren nach einem der Ansprüche 1 bis 4, **dadurch gekennzeichnet, dass** die abgelegte Materialmenge durch Veränderung eines Arbeitsgasflusses (G_{A}) in den Raum zwischen Sputterfläche (7) und Substrat (11, 27) verändert wird.

6. Verfahren nach Anspruch 3, **dadurch gekennzeichnet, dass** die abgelegte Materialmenge durch Veränderung der Sputterleistung (3) verändert wird.

7. Verfahren nach einem der Ansprüche 1 bis 6, **dadurch gekennzeichnet, dass** man die phasenverriegelte zyklische Veränderung der Materialmenge mit einem Verlauf über der Zeit vornimmt, dessen Frequenzspektrum eine dominante Spektrallinie (f₂) bei der doppelten Frequenz (2f₁) bezüglich der Frequenz (f₁) der zyklischen Bewegung des Magnetfelds hat.

8. Verfahren nach Anspruch 7, **dadurch gekennzeichnet, dass** der Verlauf eine weitere dominante Frequenzlinie bei der Frequenz (f₁) der Zyklizität der Magnetfeldmusterbewegung (f₁) hat.

9. Verfahren nach einem der Ansprüche 1 bis 8, **dadurch gekennzeichnet, dass** das Magnetron-Magnetfeld-Muster zu einer Achse in einer Ebene, die parallel zur Sputterfläche (7) ist (Fig. 4), spiegelsymmetrisch oder zu zwei aufeinander senkrechten, in der genannten Ebene liegende Achsen spiegelsymmetrisch ausgebildet ist.

10. Verfahren nach einem der Ansprüche 1 bis 9, **dadurch gekennzeichnet, dass** in den Prozessraum zwischen Sputterfläche (7) und Substrat (11, 27) ein Reaktivgas (G_{R}) vorgesehen wird.

11. Verfahren nach einem der Ansprüche 1 bis 10, **dadurch gekennzeichnet, dass** man eine kreisförmige Sputterfläche einsetzt.

12. Verfahren nach einem der Ansprüche 1 bis 11, **dadurch gekennzeichnet, dass** die Sputterfläche (7) durch das Material eines Targetkörpers gebildet ist.

13. Verfahren nach einem der Ansprüche 1 bis 12, **dadurch gekennzeichnet, dass** man zwischen Sputterfläche (7) und Substrat (11, 27) keine die Materialflussverteilung beeinflussenden Bauteile (29') vorsieht.

14. Verfahren nach einem der Ansprüche 1 bis 13, **dadurch gekennzeichnet, dass** man den Verlauf der phasenverriegelten zyklischen Veränderung in Abhängigkeit von Relativbewegung zwischen Substrat und Sputterfläche und/oder in Abhängigkeit von der Form des Magnetfeld-Musters und/oder in Abhängigkeit von der zyklischen Magnetfeldmusterbewegung wählt.

15. Verfahren nach einem der Ansprüche 1 bis 14, **dadurch gekennzeichnet, dass** man den Verlauf der phasenverriegelten zyklischen Veränderung in der Zeit ändert.

16. Verfahren nach einem der Ansprüche 1 bis 15, **dadurch gekennzeichnet, dass** man die momentan am Substrat (11, 27) abgelegte Materialmengenverteilung als gemessene Regelgrösse misst (40), mit einer Sollverteilung (44) vergleicht (42) und nach Massgabe des Vergleichsresultates, als Regeldifferenz (Δ), den Verlauf der phasenverriegelten zyklischen Veränderung (17) als Stellgrösse, in einem Regelkreis für die erwähnte Verteilung, stellt.

17. Verfahren nach einem der Ansprüche 1 bis 16, **dadurch gekennzeichnet, dass** man das Substrat (11, 27) mehrere Male über die Sputterfläche (7) bewegt.

18. Verfahren nach einem der Ansprüche 1 bis 17, **dadurch gekennzeichnet, dass** man das Substrat (11, 27) zyklisch über der Sputterfläche (7) in einer Richtung oder hin und her bewegt.

19. Verfahren nach einem der Ansprüche 1 bis 18, **dadurch gekennzeichnet, dass** man das Substrat (11, 27), in einer Ansicht gegen die Sputterfläche (7) hin, linear bewegt.

20. Verfahren nach Anspruch 19, **dadurch gekennzeichnet, dass** man das Substrat (11, 27) in einer Ebene parallel zur Sputterfläche (7) bewegt.

21. Verfahren nach Anspruch 20, **dadurch gekennzeichnet, dass** man das Substrat (11), in Ansicht parallel zur Sputterfläche (7), nichtlinear, vorzugsweise entlang einer Kreisbahn, bewegt.

22. Verfahren nach einem der Ansprüche 1 bis 18, **dadurch gekennzeichnet, dass** man das Substrat (11, 27), in Ansicht gegen die Sputterfläche (7) hin, nichtlinear, vorzugsweise entlang einer Kreisbahn mit Kreismittelpunkt ausserhalb der Sputterfläche (7) bewegt.

23. Verfahren nach Anspruch 21, **dadurch gekennzeichnet, dass** man eine zusätzliche Veränderung der pro Zeiteinheit abgelegten Materialmenge der ersterwähnten Veränderung überlagert, welche mit der Substratbewegung synchronisiert wird.

24. Verfahren nach einem der Ansprüche 1 bis 23, **dadurch gekennzeichnet, dass** Magnetron-sputterbeschichtete Substrate optimiert homogener Schichtdicken- und/oder Stöchiometrie-Verteilung hergestellt werden.

25. Verfahren nach einem der Ansprüche 1 bis 24, **dadurch gekennzeichnet, dass** magnetronsputterbeschichtete plane Substrate hergestellt werden.

26. Verfahren nach einem der Ansprüche 1 bis 25, **dadurch gekennzeichnet, dass** das hergestellte Substrat eine Schichtdickenabweichung von einem gemittelten Schichtdickenwert hat, die bei mindestens 1000 cm² Substratfläche höchstens 1 % beträgt.

27. Verfahren nach einem der Ansprüche 1 bis 23, **dadurch gekennzeichnet, dass** das hergestellte Substrat eine Abweichung der örtlich abgelegten Sputtermaterialmenge von einem gemittelten Wert hat, die bei mindestens 10 cm² Substratfläche höchstens 0,01 % beträgt.

28. Magnetronsputterbeschichtungsanlage mit
• einer Magnetronquelle und einer Magnetanordnung (5, 25) mit einem Antrieb, mittels welchem die Magnetanordnung (5, 25) unterhalb eines Sputtertargets (1, 23) und in einer Ebene parallel zur Sputterfläche (7) des Sputtertargets (1, 23) zyklisch antreibbar ist;
• einer Substrattransportanordnung, mittels welcher ein Substrat über der Sputterfläche bewegbar ist;
**dadurch gekennzeichnet, dass** eine Modulationsanordnung (Δϕ, 17, 18) vorhanden ist, mittels welcher eine zyklische Modulation der pro Zeiteinheit von der Quelle abgesputterten Materialmenge erzeugbar ist, phasenverriegelt mit der durch den Antrieb erzeugbaren zyklischen Bewegung der Magnetanordnung (5, 25).

29. Anlage nach Anspruch 28, **dadurch gekennzeichnet, dass** die Magnetanordnung (5, 25) mit einem Rotationspendel- oder - Umlaufantrieb wirkverbunden ist für eine Rotationspendel- oder -Umlaufbewegung bezüglich einer zur Sputterfläche (7) des Targets (1, 23) senkrechten Achse.

30. Anlage nach einem der Ansprüche 28 oder 29, **dadurch gekennzeichnet, dass** mittels der Modulationsanordnung (Δϕ, 17, 18) die pro Zeiteinheit von der Quelle abgesputterte Materialmenge gleichzeitig über der ganzen Sputterfläche (7) modulierbar ist.

31. Anlage nach einem der Ansprüche 28 bis 30, **dadurch gekennzeichnet, dass** die Modulationsanordnung (Δϕ, 17, 18) eine Reaktivgasfluss- und/oder Arbeitsgasfluss-Verstelleinrichtung (G_{R}, G_{A}) umfasst.

32. Anlage nach einem der Ansprüche 28 bis 31, **dadurch gekennzeichnet, dass** die Modulationsanordnung (Δϕ, 17, 18) die elektrische Speisung (3) des Sputtertargets (1, 23) umfasst.

33. Anlage nach einem der Ansprüche 28 bis 32, **dadurch gekennzeichnet, dass** die Magnetanordnung (5, 25) bezüglich einer Achse parallel zur Sputterfläche (7) oder bezüglich zweier zueinander senkrechter Achsen parallel zur Sputterfläche spiegelsymmetrisch geformt ist.

34. Anlage nach einem der Ansprüche 28 bis 33, **dadurch gekennzeichnet, dass** im Bereich der Magnetronquelle ein mit einem Reaktivgasvorrat verbundener Gaseinlass vorhanden ist.

35. Anlage nach einem der Ansprüche 28 bis 34, **dadurch gekennzeichnet, dass** die Magnetronquelle ein kreisförmiges Target (23) hat.

36. Anlage nach einem der Ansprüche 28 bis 35, **dadurch gekennzeichnet, dass** das Target (1, 23) aus einem einzigen Material besteht.

37. Anlage nach einem der Ansprüche 28 bis 36, **dadurch gekennzeichnet, dass** zwischen Sputterfläche (7) und Substrattransportanordnung kein die direkte Sichtverbindung von Sputterfläche (7) und Substrattransportanordnung behinderndes Bauteil (29') vorhanden ist.

38. Anlage nach einem der Ansprüche 28 bis 37, **dadurch gekennzeichnet, dass** eine Messvorrichtung (40) für die örtliche Verteilung der an einem Substrat (11, 27) an der Substrattransportanordnung abgelegten Menge abgesputterten Materials vorhanden ist, deren Ausgang mit dem einen Eingang einer Vergleichseinheit (42) wirkverbunden ist, deren zweiter Eingang mit einer Sollverteilungsvorgabeeinheit (44) wirkverbunden ist, und deren Ausgang mit einem Steuereingang (S₁₇) einer an der Modulationsanordnung vorgesehenen Stelleinheit (17) wirkverbunden ist.

39. Anlage nach einem der Ansprüche 28 bis 38, **dadurch gekennzeichnet, dass** die Substrattransportanordnung mit einem Antrieb (15) wirkverbunden ist, mittels welchem die mindestens eine Substrataufnahme zyklisch an der Sputterfläche (7) vorbei bewegbar ist.

## Claims

1. A method for the production of substrates coated by magnetron sputtering, in which
• a magnetron magnetic field pattern (9, 9') is cyclically moved along the sputtering surface (7) being arranged at a magnetron source;
• the substrate is moved at a distance from and above the sputtering surface (7),
**characterized in that** phase-locked (Δϕ) with the cyclical (f₁) movement of the magnetic field pattern, one cyclically changes (3) the amount of material deposited per time unit on the substrate.

2. The method according to claim 1, **characterized in that** one performs the cyclical movement of the magnetic field pattern two-dimensionally (Mₓ, M_{y}), preferably by a rotary-pendulum movement or rotary-orbital movement with respect to an axis (24) being perpendicular to the sputtering surface.

3. The method according to one of the claims 1 or 2, **characterized in that** the amount of material deposited is changed (3) cyclically over the entire sputtering surface at the same time.

4. The method according to one of the claims 1 to 3, **characterized in that** the amount of material deposited is changed by changing the flow of a reactive gas (G_{R}) into the space between the sputtering surface (7) and the substrate (11, 27).

5. The method according to one of the claims 1 to 4, **characterized in that** the amount of material deposited is changed by changing the flow of a working gas (G_{A}) into the space between the sputtering surface (7) and the substrate (11, 27).

6. The method according to claim 3, **characterized in that** the amount of material deposited is changed by changing the sputtering power (3).

7. The method according to one of the claims 1 to 6, **characterized in that** one changes the phase-locked cyclical change of the amount of material deposited by course depending on time, the frequency spectrum of the course having a dominant spectral line (f₂) at a frequency (2f₁) being twice the frequency (f₁) of the cyclical movement of the magnetic field.

8. The method according to claim 7, **characterized in that** the course has another dominant frequency line at the frequency (f₁) of the cyclicity of the movement of the magnetic field pattern (f₁).

9. The method according to one of the claims 1 to 8, **characterized in that** the magnetron magnetic field pattern is mirror-symmetrical to one axis being in a plane parallel to the sputtering surface (7) (Fig.4), or to two axes, being mutually perpendicular and lying in the mentioned plane.

10. The method according to one of the claims 1 to 9, **characterized in that** a reactive gas (G_{R}) is provided in the processing space between the sputtering surface (7) and the substrate (11, 27).

11. The method according to one of the claims 1 to 10, **characterized in that** one uses a circular sputtering surface.

12. The method according to one of the claims 1 to 11, **characterized in that** the sputtering surface (7) is formed by the material of a target body.

13. The method according to one of the claims 1 to 12, **characterized in that** one does not place building elements (29'), which influence the material flow distribution, between the sputtering surface (7) and the substrate (11, 27).

14. The method according to one of the claims 1 to 13, **characterized in that** one selects the course of the phase-locked cyclical changes depending on relative movement between substrate and sputtering surface and/or depending on the shape of the magnetic field pattern and/or depending on the movement of the cyclic magnetic field pattern.

15. The method according to one of the claims 1 to 14, **characterized in that** one changes the course of the phase-locked cyclical change in the course of time.

16. The method according to one of the claims 1 to 15, **characterized in that** one measures the distribution of the material currently deposited on the substrate (11, 27) as measured control variable (40), compares (42) it with a reference distribution (44) and in accordance with the comparison outcome as a control difference (Δ), uses the course of the phase-locked cyclical change (17) as an actuating variable in a control loop for the mentioned distribution.

17. The method according to one of the claims 1 to 16, **characterized in that** one moves the substrate (11, 27) several times over the sputtering surface (7).

18. The method according to one of the claims 1 to 17, **characterized in that** one cyclically moves the substrate (11, 27) over the sputtering surface (7) in one direction or back and forth.

19. The method according to one of the claims 1 to 18, **characterized in that** one linearly moves the substrate (11, 27), viewed towards the sputtering surface (7).

20. The method according to claim 19, **characterized in that** one moves the substrate (11, 27) in a plane being parallel to the sputtering surface (7).

21. The method according to claim 20, **characterized in that** one non-linearly moves the substrate (11), preferably along a circular path, viewed parallel to the sputtering surface (7).

22. The method according to one of the claims 1 to 18, **characterized in that** one non-linearly moves the substrate (11, 27), preferably along a circular arc with center point outside the sputtering surface (7), viewed towards the sputtering surface (7).

23. The method of claim 21, **characterized in that** one superimposes an additional change of the amount of material deposited per time unit onto the change first-mentioned, which is being synchronized to the movement of the substrate.

24. The method according to one of the claims 1 to 23, **characterized in that** substrates are produced, the substrates being coated by magnetron sputtering and being of optimized distribution of homogeneous layer thickness and/or stoichiometry.

25. The method according to one of the claims 1 to 24, **characterized in that** substrates are produced, the substrates being coated by magnetron sputtering and being plane.

26. The method according to one of the claims 1 to 25, **characterized in that** the substrate produced has a deviation of the layer thickness from an averaged layer thickness value, the deviation being at most 1 % on a substrate area of at least 1000 cm².

27. The method according to one of the claims 1 to 23, **characterized in that** the substrate produced has a deviation of the locally deposited amount of sputtered material from an average value, the deviation being at most 0.01 % on a substrate area of at least 10 cm².

28. A magnetron sputtering coating plant with
• a magnetron source and a magnet arrangement (5,25) with a drive, by means of which, the magnet arrangement (5,25) can cyclically be driven below a sputtering target (1, 2, 3) and in a plane parallel to the sputtering surface (7) of the sputtering target (1, 23);
• a substrate transport arrangement by means of which a substrate is movable above the sputtering surface;
**characterized in that** a modulation arrangement (Δϕ, 17, 18) is present, by means of which a cyclical modulation of an amount of material sputtered per time unit from the source is producible, the cyclical modulation being phase-locked with the cyclical movement of the magnet arrangement (5, 25) being producible by the drive.

29. The plant according to claim 28, **characterized in that** the magnet arrangement (5, 25) is operatively connected to a rotary-pendulum drive or rotary-orbital drive for providing a rotary-pendulum or rotary-orbital movement with respect to an axis being perpendicular to the sputtering surface (7) of the target (1, 23).

30. The plant according to one of the claims 28 or 29, **characterized in that** the amount of material sputtered per time unit from a source can be modulated over the entire sputtering surface (7) by means of the modulation arrangement (Δϕ, 17, 18).

31. The plant according to claims 28 to 30, **characterized in that** the modulation arrangement (Δϕ, 17, 18) comprises an adjustment device for controlling the flow of a reactive gas and/or a working gas (G_{R}, G_{A}).

32. The plant according to claims 28 to 31, **characterized in that** the modulation arrangement (Δϕ, 17, 18) comprises the electrical power supply (3) of the sputtering target (1, 23).

33. The plant according to claims 28 to 32, **characterized in that** the magnet arrangement (5, 25) is shaped mirror symmetrical with respect to one axis being parallel to the sputtering surface (7) or with respect to two mutually perpendicular axes being parallel to the sputtering surface.

34. The plant according to claims 28 to 33, **characterized in that** a gas inlet is present in the region of the magnetron source, the gas inlet being connected to a reactive gas supply.

35. The plant according to claims 28 to 34, **characterized in that** the magnetron source has a circular target (23).

36. The plant according to claims 28 to 35, **characterized in that** the target (1, 23) is made of a single material.

37. The plant according to claims 28 to 36, **characterized in that** between the sputtering surface (7) and the substrate transport arrangement no building elements (29') are present, which hamper the direct line of sight between the sputtering surface (7) and the substrate transport arrangement.

38. The plant according to claims 28 to 37, **characterized in that** a measuring device (40) is present for measuring the local distribution of the amount of material sputtered onto a substrate (11, 27) that is arranged at the substrate transport arrangement, the output of the measuring device being operatively connected to the one input of a comparator unit (42), of which the second input is operatively connected to a reference unit (44) that provides a predetermined reference distribution, and the output of the comparator unit (42) being operatively connected to a control input (S₁₇) of an actuation unit (17) being arranged at the modulation arrangement.

39. The plant according to claims 28 to 38, **characterized in that** the substrate transport arrangement is operatively connected to a drive (15), by means of which the at least one substrate holder is cyclically movable above the sputtering surface (7).

## Revendications

1. Procédé pour produire des substrats revêtus par pulvérisation cathodique à magnétron, auquel
• à une source à magnétron avec une surface cible (7), un champ magnétique (9,9') magnétron est déplacé cycliquement le long de la surface cible;
• le substrat est déplacé de façon distante de et au-dessus de la surface cible (7),
**caractérisé en ce qu'**on change (3) cycliquement, barré en phase (Δϕ) avec le mouvement cyclique (f₁) du champ magnétique, la quantité de matériau déposé sur le substrat par unité de temps.

2. Procédé selon la revendication 1, **caractérisé en ce qu'**on effectue le mouvement cyclique du champ magnétique de façon bidimensionnelle (M_{X}, M_{Y}), préférablement par un mouvement de rotation pendulaire ou par un mouvement de rotation circulaire par rapport à un axe vertical (24) relative à la surface cible.

3. Procédé selon une des revendications 1 ou 2, **caractérisé en ce que** la quantité du matériau déposé est changée de façon cyclique simultanément le long de la surface cible entière.

4. Procédé selon une des revendications 1 à 3, **caractérisé en ce que** la quantité du matériau déposé est changée par changement d'un flux de gaz réactif (G_{R}) dans l'espace entre la surface cible (7) et le substrat (11, 27).

5. Procédé selon une des revendications 1 à 4, **caractérisé en ce que** la quantité du matériau déposé est changée par changement d'un flux de gaz de travail (G_{A}) dans l'espace entre la surface cible (7) et le substrat (11, 27).

6. Procédé selon la revendication 3, **caractérisé en ce que** la quantité du matériau déposé est changée par changement de la puissance de la pulvérisation cathodique (3).

7. Procédé selon une des revendications 1 à 6, **caractérisé en ce que** le changement cyclique barré en phase de la quantité du matériau est effectué avec un déroulement sur le temps, dont le spectre de fréquence a une ligne spectrale dominante (f₂) égale à la double fréquence (2f₁) de la fréquence (f₁) du mouvement cyclique du champ magnétique.

8. Procédé selon la revendication 7, **caractérisé en ce que** le déroulement a de plus une ligne de fréquence dominante égale à la fréquence (f₁) de la cyclicité du mouvement du champ magnétique (f₁).

9. Procédé selon une des revendications 1 à 8, **caractérisé en ce que** le champ magnétique magnétron est façonné par rapport à un axe dans un plan, parallèle à la surface cible (7) (Fig. 4), de manière symétrique ou par rapport à deux axes perpendiculaires dans ledit plan.

10. Procédé selon une des revendications 1 à 9, **caractérisé en ce qu'**un gaz réactif (G_{R}) est prévu dans l'espace de processus entre la surface cible (7) et le substrat (11, 27).

11. Procédé selon une des revendications 1 à 10, **caractérisé en ce qu'**on utilise une surface cible circulaire.

12. Procédé selon une des revendications 1 à 11, **caractérisé en ce que** la surface cible (7) est formée par le matériau d'un corps de cible.

13. Procédé selon une des revendications 1 à 12, **caractérisé en ce qu'**on ne prévoit pas d'éléments de construction (29') qui influencent la distribution du flux de matériau entre la surface cible (7) et les substrats (11, 27).

14. Procédé selon une des revendications 1 à 13, **caractérisé en ce qu'**on choisit le déroulement cyclique du changement barré en phase en dépendance du mouvement relatif entre le substrat et la surface cible et/ou en dépendance de la forme du champ magnétique et/ou en dépendance du mouvement cyclique du champ magnétique.

15. Procédé selon une des revendications 1 à 14, **caractérisé en ce qu'**on change le déroulement dans le temps du changement cyclique barré en phase.

16. Procédé selon une des revendications 1 à 15, **caractérisé en ce qu'**on mesure la distribution de la quantité du matériau déposé au substrat (11, 27) momentanée comme grandeur de réglage mesurée (40), la compare (42) avec une distribution prévisionnelle (44) et qu'on règle, conformément au résultat de comparaison comme différence de réglage (Δ), le déroulement du changement cyclique barré en phase (17) comme grandeur de commande, dans un circuit de réglage pour la distribution mentionnée.

17. Procédé selon une des revendications 1 à 16, **caractérisé en ce qu'**on déplace le substrat (11, 27) plusieurs fois au-dessus de la surface cible (7).

18. Procédé selon une des revendications 1 à 17, **caractérisé en ce qu'**on déplace le substrat (11, 27) de façon cyclique au-dessus de la surface cible (7) dans une direction ou de façon çà et là.

19. Procédé selon une des revendications 1 à 18, **caractérisé en ce qu'**on déplace linéairement le substrat (11, 27) sous un aspect contre la surface cible (7).

20. Procédé selon la revendication 19, **caractérisé en ce qu'**on déplace le substrat (11, 27) dans un plan parallèle par rapport à la surface cible (7).

21. Procédé selon la revendication 20, **caractérisé en ce qu'**on déplace le substrat (11) sous un aspect parallèle à la surface cible (7), non-linéairement, préférablement le long d'une orbite.

22. Procédé selon une des revendications 1 à 18, **caractérisé en ce qu'**on déplace le substrat (11, 27) sous un aspect contre la surface cible (7), non-linéairement, préférablement le long d'une orbite avec un centre de l'orbite en dehors de la surface cible (7).

23. Procédé selon la revendication 21, **caractérisé en ce qu'**on superpose un changement de la quantité de matériau déposé par unité de temps additionnel au changement mentionné qui est synchronisé avec le mouvement du substrat.

24. Procédé selon une des revendications 1 à 23, **caractérisé en ce que** les substrats revêtus par pulvérisation cathodique à magnétron sont produits de façon optimisée en ce qui concerne la distribution d'épaisseur de couche homogène et/ou la distribution de stoechiométrie.

25. Procédé selon une des revendications 1 à 24, **caractérisé en ce que** des substrats revêtus par pulvérisation cathodique à magnétron plans sont produits.

26. Procédé selon une des revendications 1 à 25, **caractérisé en ce que** le substrat produit a une déviation d'épaisseur de couche d'une valeur d'épaisseur de couche moyennée, qui, à une surface de substrat d'au moins 1000 cm², se monte au maximum à 1 %.

27. Procédé selon une des revendications 1 à 23, **caractérisé en ce que** le substrat produit a une déviation de la quantité du matériau déposé localement par la pulvérisation cathodique d'une valeur moyennée, qui se monte, à une surface de substrat d'au moins 10 cm², au maximum à 0,01 %.

28. Installation de pulvérisation cathodique à magnétron ayant
• une source de magnétron et un arrangement d'aimant (5, 25) avec un actionnement, au moyen duquel l'arrangement d'aimant (5, 25) est cycliquement actionnable en-dessous d'une cible de pulvérisation cathodique (1, 23) et dans un plan parallèle par rapport à la surface cible (7) de la cible de pulvérisation cathodique (1, 23);
• un arrangement de transport de substrat, au moyen duquel un substrat est déplaçable au-dessus de la surface cible;
**caractérisé en ce qu'**un arrangement de modulation (Δϕ, 17, 18) est présent, au moyen duquel une modulation cyclique de la quantité de matériau pulvérisé de la source par unité de temps est générable, barré en phase avec le mouvement cyclique de l'arrangement d'aimant (5, 25), générable par l'actionnement.

29. Installation selon la revendication 28, **caractérisé en ce que** l'arrangement d'aimant (5, 25) est relié fonctionnellement avec un actionnement de pendule rotatif ou avec un actionnement en boucle pour un mouvement de rotation pendulaire ou pour un mouvement en boucle par rapport à un axe perpendiculaire relatif à la surface cible (7) du cible (1, 23).

30. Installation selon une des revendications 28 ou 29, **caractérisé en ce qu'**au moyen de l'arrangement de modulation (Δ, 17, 18) la quantité du matériau pulvérisée cathodiquement par unité de temps de la source est modulable simultanément le long de la surface cible (7) entière.

31. Installation selon une des revendications 28 à 30, **caractérisé en ce que** l'arrangement de modulation (Δϕ, 17, 18) comprend une installation d'ajustage de flux de gaz réactif et/ou une installation d'ajustage de flux de gaz à travail (G_{R}, G_{A}).

32. Installation selon une des revendications 28 à 31, **caractérisé en ce que** l'arrangement de modulation (Δϕ, 17, 18) comprend l'alimentation électrique (3) du cible (1, 23).

33. Installation selon une des revendications 28 à 32, **caractérisé en ce que** l'arrangement d'aimant (5, 25) est formé de façon symétrique à une axe parallèle à la surface cible (7) ou de façon symétrique par rapport à deux axes perpendiculaires parallèles à la surface cible.

34. Installation selon une des revendications 28 à 33, **caractérisé en ce qu'**une entrée de gaz est prévue dans la région de la source à magnétron qui est reliée à un stock de gaz réactif.

35. Installation selon une des revendications 28 à 34, **caractérisé en ce que** la source à magnétron a une cible (23) circulaire.

36. Installation selon une des revendications 28 à 35, **caractérisé en ce que** la cible (1, 23) consiste en un seul matériau.

37. Installation selon une des revendications 28 à 36, **caractérisé en ce qu'**entre la surface cible (7) et l'arrangement de transport de substrat aucun élément de construction (29') est prévu qui contrarie la visibilité directe entre la surface cible (7) et l'arrangement de transport de substrat.

38. Installation selon une des revendications 28 à 37, **caractérisé en ce qu'**un dispositif de mesurage (40) pour la distribution locale de la quantité du matériau déposé sur un substrat (11, 27) sur l'arrangement de transport de substrat est prévu, dont la sortie est reliée fonctionnellement à une entrée d'une unité de comparaison (42), dont la deuxième entrée est reliée fonctionnellement à une unité de choix de la distribution désirée (44), et dont la sortie est reliée fonctionnellement à une entrée d'ajustement (S₁₇) d'une unité d'ajustement (17) prévue à l'arrangement de modulation.

39. Installation selon une des revendications 28 à 38, **caractérisé en ce que** l'arrangement de transport de substrat est relié fonctionnellement avec un actionnement, au moyen duquel au moins un support de substrat est cycliquement déplaçable le long de la surface cible (7).
